Europäisches Patentamt

European Patent Office

Office européen des brevets

(19)

(11) Numéro de publication : **0 128 062**
**B1**

(12) **FASCICULE DE BREVET EUROPÉEN**

(45) Date de publication du fascicule du brevet :
11.02.87

(51) Int. Cl.⁴ : **H 01 L 29/64, H 01 L 29/62, H 01 L 29/80**

(21) Numéro de dépôt : 84400902.7

(22) Date de dépôt : 03.05.84

(54) **Transistor à effet de champ, fonctionnant en régime d'enrichissement.**

(30) Priorité : 10.05.83 FR 8307792

(43) Date de publication de la demande :
12.12.84 Bulletin 84/50

(45) Mention de la délivrance du brevet :
11.02.87 Bulletin 87/07

(84) Etats contractants désignés :
DE GB NL

(56) Documents cités :
DE-A- 1 923 279
IBM TECHNICAL DISCLOSURE BULLETIN, vol. 24, no. 5, octobre 1981, page 2452, New York, US; T.L. ANDRADE et al.: "GaAs lossy gate dielectric FET"
JOURNAL OF THE ELECTROCHEMICAL SOCIETY, vol. 117, no. 11, novembre 1970, pages 1410-1417; J.E. FOSTER et al.: "Electrical characteristics of the silicon nitride-gallium arsenide interface"
IBM TECHNICAL DISCLOSURE BULLETIN, vol. 24, no. 7A, décembre 1981, page 3485, New York, US; J. BOITUZAT et al.: "Characterization method of metalloid contamination in the plasma etching step of Schottky barrier diodes"
JAPANESE JOURNAL OF APPLIED PHYSICS, vol. 21, no. 2, partie 2, février 1982, pages L122-L124, Tokyo, JP; T. HOTTA et al.: "A new AlGaAs/GaAs heterojunction FET with insulated gate structure (MISSFET)"
APPLIED PHYSICS LETTERS, vol. 37, no. 1, juillet 1980, pages 61-64, American Institute of Physics, New York, US; D.J. DIMARIA et al.: "Dual electron injector structure"
ELECTRONICS LETTERS, vol. 19, no. 12, juin 1983, pages 434-435, Londres, GB; E. KOHN et al.: "MIM gate FET: new GaAs enhancement-mode transistor"

(73) Titulaire : THOMSON-CSF
173, Boulevard Haussmann
F-75379 Paris Cedex 08 (FR)

(72) Inventeur : Kohn, Erhard
THOMSON-CFS SCPI 173, bld Haussmann
F-75379 Paris Cedex 08 (FR)
Inventeur : Dortu, Jean-Marc
THOMSON-CFS SCPI 173, bld Haussmann
F-75379 Paris Cedex 08 (FR)

(74) Mandataire : Taboureau, James et al
THOMSON-CSF SCPI 19, avenue de Messine
F-75008 Paris (FR)

Jouve, 18, rue St-Denis, 75001 Paris, France

EP 0 128 062 B1

## Description

La présente invention concerne un transistor à effet de champ, fonctionnant en hyperfréquence, du type à enrichissement, dans lequel l'électrode de commande a une structure métal-isolant-métal, selon laquelle le premier métal assure un contact Schottky avec la couche active du transistor, l'isolant ou diélectrique présente une fuite diélectrique contrôlée, et le second métal constitue la grille de contrôle sur laquelle est appliquée la tension de polarisation.

L'article de T. L. Andrade et al, paru dans « IBM Technical Disclosure Bulletin », vol. 24, No. 5, oct. 1981, page 2452. « Gras lossy gate dielectric FET » décrit un GaAs MISFET dans lequel le diélectrique de la grille présente une fuite électrique contrôlée.

La technologie des circuits intégrés sur matériaux rapides tels que GaAs en particulier utilise principalement comme éléments actifs des transistors à effet de champ à grille Schottky. Dans ces transistors, la grille est constituée par une métallisation qui assure un contact Schottky avec la couche active du transistor sur laquelle elle est déposée : ces transistors sont fréquemment appelés selon leur dénomination internationale MESFET, c'est-à-dire transistor métal semiconducteur.

Les MESFET peuvent travailler en régime de désertion, pour lesquels la tension de grille est négative, la zone de charge d'espace située sous la grille modulant le canal entre les électrodes d'accès du transistor, la source et le drain. Ils peuvent également travailler en régime d'enrichissement limité : il existe une zone désertée pour une tension de grille nulle, zone que l'on peut réduire en appliquant une faible tension positive $V_G$ sur la grille. En fait, cette tension positive est limitée par la hauteur de barrière métal-semiconducteur, dans les diagrammes d'énergie, à une valeur voisine de + 0,6 V en pratique, tension au-delà de laquelle la grille commence à fuir de façon importante.

Pour les applications logiques, il est souhaitable de pouvoir travailler en régime d'enrichissement, en particulier s'il est possible de pincer le canal entre source et drain pour une tension de grille nulle, c'est-à-dire avec des transistors normalement bloqués. La réalisation de MESFET normalement bloqués et limitée par cette valeur de + 0,6 V, sur GaAs en raison de la fuite de grille.

Une solution qui semble possible, celle de transistors MOS, c'est-à-dire métal-oxyde-semiconducteur, sur GaAs présente de sérieux problèmes d'instabilité dûs aux états d'interface entre les couches métalliques, isolantes et semiconductrices, qui se chargent et se déchargent, cette instabilité se manifeste par des déplacements de la courbe de capacité en fonction de la tension, la capacité étant formée par la métalisation de grille, la couche d'oxyde et la couche semiconductrice, après polarisation ainsi que par une réduction de la transconductance aux basses fréquences.

Ces difficultés sont résolues par l'utilisation d'une grille de transistor à effet de champ couplée capacitivement, le diélectrique de la capacité de grille présentant une légère fuite électrique, contrôlée, suffisante pour permettre de maintenir en équilibre électrique les deux métallisations qui constituent la grille du transistor selon l'invention, mais cependant suffisamment faible pour limiter le courant de la diode formée par la grille et la couche active du transistor, cette limitation permettant de travailler jusqu'à + 1,5 V de tension de polarisation.

De façon plus précise, l'invention concerne un transistor à effet de champ, fonctionnant en régime d'enrichissement, comportant, supportées par un substrat en matériau semi-isolant, au moins une couche active et deux électrodes d'accès dites source et drain, caractérisé en ce que l'électrode de commande, dite grille, a une structure capacitive composée de :

— une première métallisation, déposée sur la couche active et formant avec elle une jonction Schottky,

— une couche diélectrique, déposée sur la première métallisation, cette couche présentant une fuite électrique contrôlée,

— une seconde métallisation, déposée sur la couche diélectrique, formant grille de contrôle, cette métallisation étant celle sur laquelle est appliquée la tension de polarisation de grille.

L'invention sera mieux comprise par la description d'un exemple de réalisation d'un transistor, ainsi que de l'une de ses variantes possibles, cette description s'appuyant sur les figures jointes en annexe qui représentent :

figure 1   schéma en coupe d'un transistor selon l'invention,

figure 2   schéma en coupe d'un transistor selon l'invention, dans une variante de réalisation,

figure 3   courbes de caractéristiques I/V d'un transistor   métal/semiconducteur   selon   l'art connu,

figure 4   courbes de caractéristiques I/V d'un transistor   métal/isolant/semiconducteur   selon l'art connu,

figure 5   courbe de caractéristique I/V d'un transistor   métal/isolant   présentant   une fuite/métal/semiconducteur selon l'invention.

Pour simplifier le texte, on conviendra de désigner par MESFET un transistor selon l'art connu dont la grille métallique est déposée directement sur la couche active ; par MISFET un transistor selon l'art connu dont la grille métallique est déposée sur une couche d'isolant elle-même déposée sur le matériau semiconducteur ; et par MIMFET le transistor selon l'invention dans lequel la grille a une structure métal-isolant-métal.

Des résultats très intéressants ont été obtenus récemment avec les transistors de type MESFET sur matériau tel que GaAs, fonctionnant en régime d'enrichissement. Cependant, les MESFET ont l'inconvénient d'avoir une capacité de courant assez limitée selon le régime d'enrichissement et présentent le risque d'une destruction de la diode formée par la grille et la couche active, pour des tensions de polarisation positives. Ces difficultés peuvent être contournées en utilisant une grille couplée capacitivement, c'est-à-dire en utilisant un transistor dit MISFET dans lequel une couche d'isolant sépare la métallisation de grille de la couche active. Mais la distribution des états d'interface dans un transistor de type MIS, ou de type MOS, ce qui n'est qu'une forme particulière d'un MIS, ne permet pas d'opérer dans des conditions de polarisation stables si le transistor est réalisé sur GaAs.

En effet, si l'isolant placé entre la métallisation de grille et la couche active semiconductrice du transistor est parfait et présente une résistivité vraiment très élevée, les charges électriques ne peuvent pas s'écouler à travers cette couche d'isolant, et il n'y a pas d'équilibre électrique stable, les charges dues aux états d'interface se déplaçant de façon non contrôlée.

La structure de grille proposée par l'invention utilise une grille comportant un premier métal qui forme la jonction Schottky avec la couche active du transistor, puis une couche de diélectrique, c'est-à-dire d'isolant, présentant une fuite électrique contrôlée par construction, au cours de la réalisation du transistor, et enfin une seconde couche métallique déposée sur la couche diélectrique, ladite seconde couche métallique constituant l'électrode externe, ou grille de commande, sur laquelle est appliquée la tension de polarisation.

La fuite dans la couche d'isolant est choisie de telle façon que, d'une part, la métallisation Schottky, en contact avec le matériau semiconducteur, soit maintenue en équilibre électrique avec la grille de contrôle, ou seconde métallisation supérieure, jusqu'à une tension de polarisation positive voisine des conditions de bandes plates ; et pour que d'autre part le courant dans la diode formée par la grille complexe et la jonction avec la couche active du transistor, soit limitée pour des tensions de polarisation plus élevées, la préservant ainsi de la destruction. Par bandes plates, on entend les bandes de conduction et de valence, dans les diagrammes d'énergie, celles-ci ne présentant plus pour certaines valeurs de tension telles que + 0,6 V de barrière entre le métal et le semiconducteur. Par tension de polarisation élevée, on entend des tensions de polarisation de grille supérieures à 0,6 V, puisque dans les transistors selon l'art connu la grille commence à fuir pour des tensions de l'ordre de 0,6 V, 0,55 à 0,65 V selon les réalisations.

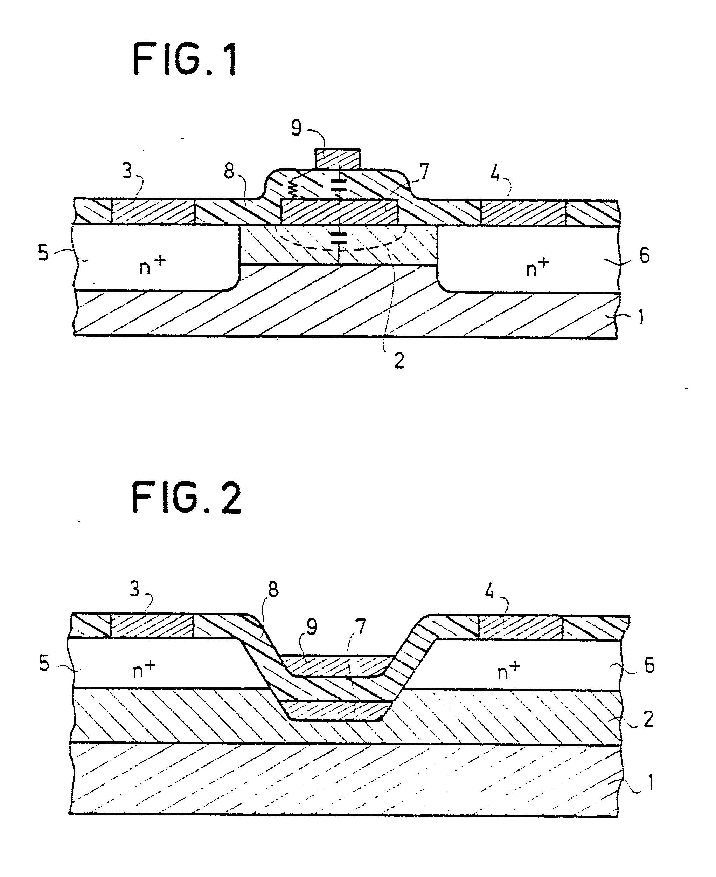

La figure 1 représente un schéma simplifié, en coupe, d'un transistor MIMFET selon l'invention. Un substrat 1, en matériau de la famille III-V, mais plus fréquemment en GaAs ou InP, semi-isolant, supporte une couche active 2. Le transistor comporte deux électrodes d'accès 3 et 4, dont l'une constitue la source et l'autre constitue le drain du transistor, ces électrodes d'accès étant avantageusement placées sur des caissons 5 et 6 qui limitent une partie de la couche active 2, en vue de diminuer la résistance série source-drain.

Le transistor à enrichissement selon l'invention comporte une électrode de commande, généralement appelée grille, qui dans le cas présent a une structure complexe formée par une première métallisation 7, formant contact Schottky avec la couche active 2, puis par une couche 8 d'un isolant présentant une fuite électrique contrôlée, et enfin par une seconde métallisation 9 formant la grille de contrôle sur laquelle est appliquée la tension de polarisation.

La première métallisation 7, l'isolant présentant une fuite 8, et la seconde métallisation 9, forment un condensateur, et comme le diélectrique 8 de ce condensateur présente une fuite électrique, l'interface Schottky 7 et la grille de contrôle 9 sont maintenues en équilibre électrique. Aux basses fréquences, ou en régime statique, la fuite du diélectrique court-circuite la capacité formée par les deux métallisations et le diélectrique. La transconductance et la tension de pincement sont identiques à celles d'un MESFET équivalent, selon l'art connu.

En fait, ce type de transistor est conçu pour travailler à des fréquences très élevées : aux hautes fréquences, ou en régime dynamique, la capacité du diélectrique est en série avec la capacité de charge d'espace sous la grille, ce qui diminue la transconductance et la tension de pincement du canal.

Sur la figure 1 ont été représentés les schémas symboliques d'une résistance qui représente la fuite contrôlée de la couche de diélectrique 8 et d'une capacité qui représente la capacité du condensateur formé par la grille complexe métal-isolant-métal. Est représentée également en pointillé la charge d'espace sous la grille Schottky et la capacité de ladite charge d'espace.

Bien que le transistor selon l'invention présente une dispersion théorique de ses caractéristiques en basses fréquences ou en hautes fréquences, selon que la résistance de fuite court-circuite une capacité ou que deux capacités sont en série, il est possible de minimiser la dispersion de la transconductance en utilisant comme matériau diélectrique 8 pour la grille un matériau ayant une constante diélectrique élevée, comprise préférentiellement entre 8 et 30.

Les matériaux préférés pour réaliser une grille MIM selon l'invention sont des oxydes non stoechiométriques de titane, de tantale ou d'aluminium, pour lesquels les constantes diélectriques sont, respectivement, de l'ordre de 30, 26 et 12, celles-ci pouvant varier selon la stoechiométrie de l'oxyde. Le nitrure de silicium, dopé ou non par un métal et répondant à la formule générale $Si_xN_yM_z$, qui a une constante diélectrique voisine de 8 à 10 selon le dopage par un métal M convient parfaitement à la réalisation d'une grille MIM selon l'invention. La première métallisation 7 est essentiellement constituée d'un métal formant un contact Schottky avec la couche active 2 : le titane et l'aluminium, par exemple, sont des métaux très couramment utilisés pour cet usage.

La seconde métallisation 9 qui constitue essentiellement une prise de contact pour apporter une polarisation à la grille du transistor doit avoir pour première qualité de bien s'accrocher à la couche de diélectrique : elle peut être par exemple formée par une suite de métallisations titane, platine, or, ensuite rechargée à l'or s'il est nécessaire de prendre un contact sur cette grille de commande 9.

Les électrodes de source et de drain 3 et 4 sont réalisées en tectique AuGeNi par exemple comme cela est courant, et la réalisation de la couche active 2, des caissons 5 et 6 ainsi que des électrodes métalliques 3 et 4 est bien connue et sort du domaine de l'invention. La figure 1 représente un transistor à effet de champ MIM selon l'invention, réalisé sur matériaux de type GaAs et la couche active ainsi que les caissons sont de type n.

La figure 2 représente une variante du transistor selon l'invention, et les mêmes indices de repère ont été conservés pour désigner les mêmes éléments de la figure. L'intérêt de cette figure 2 réside d'une part dans la réalisation d'une grille enterrée, en contact direct avec une couche active 2 qui n'est plus délimitée comme dans la figure 1 par deux caissons 5 et 6. Cette figure montre également que la couche de diélectrique interposée entre les deux couches métalliques 7 et 9 de la grille peut avantageusement être prolongée sur toute la surface libre d'accès du transistor, et servir de passivant.

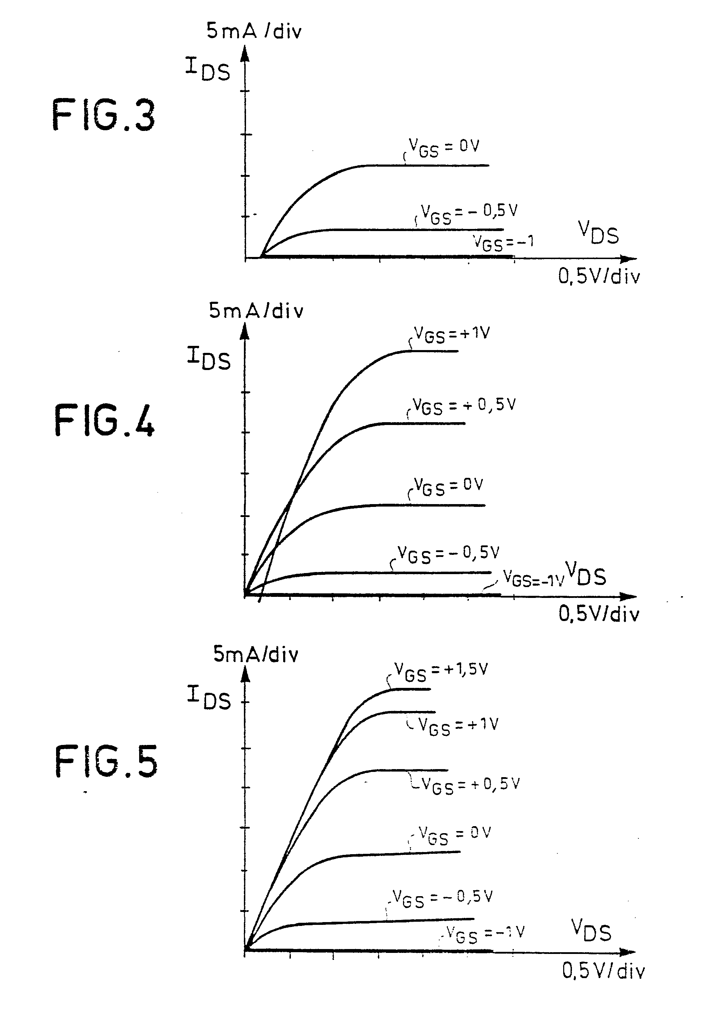

Les figures 3, 4 et 5 permettent de comparer les caractéristiques de courant drain-source $I_{DS}$ en fonction de la tension drain-source $V_{DS}$ pour différents types de transistors selon l'art connu et selon l'invention. Pour toutes ces figures, la tension $V_{DS}$ est portée en abcisses, à raison de 0,5 V par division, et le courant $I_{DS}$ est porté en ordonnées, à raison de 5 milliampères par division. Pour une même figure, les différentes courbes correspondent à différentes valeurs de polarisation de la grille, ces valeurs étant reportées sur la partie droite de chaque diagramme.

La figure 3 représente les courbes de caractéristiques normales d'un transistor à effet de champ de type MESFET. Ces courbes de caractéristiques serviront de points de repère pour les figures 4 et 5.

En figure 4, une tension de grille positive est appliquée sur un transistor de type MESFET selon l'art connu. On voit que la courbe supérieure, correspondant à une tension de polarisation $V_G$ de + 1 V, montre une fuite de grille. Cette fuite se traduit sur le diagramme par un déplacement de ladite courbe de caractéristiques, au voisinage de l'origine des coordonnées, la courbe de caractéristiques pour $V_G$ = + 1 V recoupant les autres courbes pour lesquelles $V_G$ = — 1, — 0,5, 0, et + 0,5 V. Une analyse plus détaillée, c'est-à-dire l'analyse du transistor en essais soumis à des tensions de grille qui ne procèdent plus par pas de 0,5 V mais par pas de 1/10ème de volt par exemple, montre que le phénomène de fuite de grille apparaît aux environs de + 0,55 V dans le cas d'un MESFET sur GaAs.

La figure 5 représente les mêmes caractéristiques pour un transistor MIM selon l'invention. Cette figure montre que dans l'intervalle compris entre — 1 V et + 0,5 V les courbes d'un transistor selon l'invention sont exactement identiques aux courbes d'un transistor MESFET selon l'art connu, mais que, en outre, la tension de polarisation de grille peut être poussée jusqu'à + 1,5 V, c'est-à-dire presque 3 fois la valeur limite des transistors de l'art connu sans qu'il y ait de fuite de grille.

Ces résultats particulièrement intéressants sont obtenus grâce à la structure de la grille d'un transistor MIM, cette structure permettant l'équilibre et l'écoulement des charges électriques à travers la couche de diélectrique présentant une fuite. En outre, à + 1,5 V de tension de polarisation de grille, la diode formée par la capacité de grille et la couche active du semiconducteur n'est pas détruite, ce qui est fréquemment le cas avec des transistors selon l'art connu. Pour un transistor MIM selon l'invention, le courant de canal en enrichissement est d'environ 100 % plus élevé que celui d'un MESFET classique, et la transconductance de ce dispositif est d'environ 100 milli siemens par millimètre au maximum.

La comparaison entre les trois figures 3, 4 et 5, est d'autant plus intéressante que les caractéristiques des figures 3 et 4 ont été tracées en utilisant l'électrode Schottky 7 d'un transistor selon l'invention, sur laquelle a été directement appliquée la tension de polarisation. Dans ce cas, la couche de diélectrique 8 et l'électrode de commande 9 n'ont aucune fonction, et le transistor selon l'invention, commandé directement par sa métallisation Schottky, se comporte comme un MESFET selon l'art connu. Par contre, pour la figure 5 la tension de polarisation a été appliquée sur la grille de commande 9, conformément à l'invention.

Les opérations de fabrication d'un transistor MIM selon l'invention appartiennent aux connaissances de l'homme de l'art, et sont classiques. Cependant, dans le cas d'un transistor présentant une grille enterrée comme en figure 2, la profondeur du canal est d'environ 40 nm (400 angströms). L'épaisseur de la couche d'isolant 8 est de l'ordre de 50 nm (500 angströms), et si le nitrure de silicium riche en silicium, c'est-à-dire non stœchiométrique, est utilisé pour fabriquer cette couche, il est déposé par plasma et décomposition chimique en phase vapeur, en contrôlant l'épaisseur, voisine de 50 nm (500 angströms), de façon à contrôler la fuite de courant à travers ladite couche diélectrique, de même qu'en contrôlant le dopage éventuel de cette couche par un métal puisque c'est l'apport de métal qui contrôle la fuite électrique à travers la couche.

Le transistor selon l'invention ou MIMFET dispose de caractéristiques de transconductance équivalentes à celles d'un MESFET, mais sa capacité de transfert du courant, en enrichissement, est accrue de l'ordre de 100 % par rapport à celle d'un MESFET conventionnel, et la fuite à travers la grille est supprimée jusqu'à des valeurs de polarisation de grille de l'ordre de + 1,5 V. Ce transistor MIMFET est essentiellement utilisé pour réaliser des circuits intégrés logiques, préférentiellement sur matériaux rapides du groupe III-V, tel que GaAs, $Al_xGa_{1-x}As$, InP, In GaAs mais il est concevable de l'utiliser également sur silicium bien que la rapidité des circuits intégrés sur silicium soit moins intéressante que celle des circuits intégrés sur GaAs.

L'invention est précisée par les revendications suivantes.

## Revendications

1. Transistor à effet de champ, fonctionnant en régime d'enrichissement, comportant, supportées par un substrat (1) en matériau semi-isolant, au moins une couche active (2) et deux électrodes d'accès (3, 4) dites source et drain, caractérisé en ce que l'électrode de commande, dite grille, a une structure capacitive composée de :
— une première métallisation (7), déposée sur la couche active (2) et formant avec elle une jonction Schottky,
— une couche diélectrique (8), déposée sur la première métallisation (7), cette couche (8) présentant une fuite électrique contrôlée,
— une seconde métallisation (9), déposée sur la couche diélectrique (8), formant grille de contrôle, cette métallisation (9) étant celle sur laquelle est appliquée la tension de polarisation de grille.

2. Transistor à effet de champ selon la revendication 1, caractérisé en ce que la fuite électrique à travers la couche diélectrique (8) est déterminée pour que les charges électriques stockées à l'interface Schottky (7) soient en équilibre électrique avec la grille de contrôle (9), jusqu'à une tension de polarisation positive (+ 1,5 V) sensiblement double de celle pour laquelle les bandes de conduction et de valence du diagramme d'énergie dudit interface (7) sont plates.

3. Transistor à effet de champ selon la revendication 1, caractérisé en ce que la fuite électrique à travers la couche diélectrique (8) est limitée pour que le courant dans la diode formée par la grille (7 + 8 + 9) et la jonction Schottky (7 + 2) soit limité pour des valeurs élevées de tension de polarisation.

4. Transistor à effet de champ selon la revendication 1, caractérisé en ce que la couche de diélectrique (8) présentant une fuite électrique a une constante diélectrique $8 \leqslant \varepsilon \leqslant 30$.

5. Transistor à effet de champ selon la revendication 4, caractérisé en ce que la couche de diélectrique (8) présentant une fuite électrique a une épaisseur de l'ordre de 50 nm (500 angströms) et est composée de l'un parmi les matériaux suivants : $Ti_xO_y$, $Ta_xO_y$, $Al_xO_y$ ou $Si_xN_y$, chacun de ces matériaux étant en proportions non stoechiométriques et riche en métal.

6. Transistor à effet de champ selon la revendication 5, caractérisé en ce que la résistivité de la couche de diélectrique (8) présentant une fuite électrique est contrôlée par dopage du matériau qui la constitue par un métal.

7. Transistor à effet de champ selon la revendication 1, caractérisé en ce que :
— la première métallisation (7), formant jonction Schottky, est réalisée avec des métaux tels que Ti et Al,
— la seconde métallisation (9), formant grille de contrôle, est réalisée avec des métaux qui adhèrent bien sur la couche de diélectrique (8), tels que Ti-Pt-Au.

8. Transistor à effet de champ selon la revendication 1, caractérisé en ce que la tension de polarisation de grille, en enrichissement, appliquée sur la seconde métallisation (9), est au moins le double de la tension, admissible sur la première métallisation (7), sans créer de fuite de grille importante par rapport au courant de canal.

## Claims

1. Field effect transistor operating in the enrichment condition, comprising, carried by a substrate (1) of semiconductor material, at least one active layer (2) and two access electrodes (3, 4) referred to as source and drain, characterized in that the control electrode, referred to as gate, has a capacitive structure composed of :
— a first metallization (7) deposited on the active layer (2) and forming a Schottky junction therewith,
— a dielectric layer (8) deposited on the first metallization (7), this layer (8) having a controlled electric leakage,
— a second metallization (9) deposited on the dielectric layer (8) forming the control gate, this metallization (9) being that whereon the gate polarization voltage is applied.

2. Field effect transistor according to claim 1, characterized in that the electric leakage through the dielectric layer (8) is determined in such a manner that the electric charges stored at the Schottky interface (7) are electrically balanced with the control gate (9) up to a positive polarization voltage (+ 1.5 V) of substantially twice the voltage wherefor the conduction and valance bands of the energy diagram of the said interface (7) are flat.

3. Field effect transistor according to claim 1, characterized in that the electric leakage through the dielectric layer (8) is limited in such a manner that the current within the diode formed by the gate (7 + 8 + 9) and the Schottky junction (7 + 2) is limited for high polarization voltage values.

4. Field effect transistor according to claim 1, characterized in that the dielectric layer (8) having an electric leakage has a dielectric constant such that $8 \leqslant \varepsilon \leqslant 30$.

5. Field effect transistor according to claim 4, characterized in that the dielectric layer (8) having an electric leakage has a thickness of the order of 50 nm (500 angströms) and is composed of one among the following materials : $Ti_xO_y$, $Ta_xO_y$,

$Al_xO_y$ or $Si_xN_y$, each of these materials being in non-stoichiometric proportions and rich of metal.

6. Field effect transistor according to claim 5, characterized in that the resistivity of the dielectric layer (8) having an electric leakage is controlled by doping the material whereof it is made with a metal.

7. Field effect transistor according to claim 1, characterized in that :
— the first metallization (7) forming the Schottky junction is formed with metals such as Ti and Al,
— the second metallization (9) forming the control gate is formed of metals with good adhesive properties on the dielectric layer (8), such as Ti-Pt-Au.

8. Field effect transistor according to claim 1, characterized in that the gate polarization voltage in the enrichment condition and applied on the metallization (9) is at least twice that of the voltage admissible on the first metallization (7) without causing a gate leakage which is high with respect to the channel current.

**Patentansprüche**

1. Feldeffekttransistor, der im Anreicherungsbetrieb arbeitet und von einem Substrat (1) aus Halbleitermaterial getragen wenigstens eine aktive Schicht (2) und zwei Zugangselektroden (3, 4) aufweist, die als Source und Drain bezeichnet werden, dadurch gekennzeichnet, daß die als Gate bezeichnete Steuerelektrode eine kapazitive Struktur aufweist, die zusammengesetzt ist aus :
— einer ersten Metallisierung (7), welche auf der aktiven Schicht (2) aufgebracht ist und mit ihr einen Schottky-Übergang bildet,
— einer dielektrischen Schicht (8), welche auf der ersten Metallisierung (7) abgelagert ist, wobei diese Schicht (8) einen gesteuerten elektrischen Verlust aufweist,
— eine zweite Metallisierung (9), die auf der dielektrischen Schicht (8) abgelagert ist und ein Steuergate bildet, wobei diese Metallisierung (9) diejenige ist, an welche die Gate-Polarisationsspannung angelegt wird.

2. Feldeffekttransistor nach Anspruch 1, dadurch gekennzeichnet, daß der elektrische Verlust durch die dielektrische Schicht (8) hindurch derart ausgelegt ist, daß die an der Schottky-Grenzfläche (7) gespeicherten elektrischen Ladungen im elektrischen Gleichgewicht mit dem Steuergate (9) stehen, bis zu einer positiven Polarisationsspannung (+ 1,5 V), die ungefähr den doppelten Wert derjenigen Spannung aufweist, für welche die Leitungs- und Valenzbänder des Energiediagramms der Grenzfläche (7) flach sind.

3. Feldeffekttransistor nach Anspruch 1, dadurch gekennzeichnet, daß der elektrische Verlust durch die dielektrische Schicht (8) in solcher Weise begrenzt ist, daß der Strom in der Diode, welche durch das Gate (7 + 8 + 9) und den Schottky-Übergang (7 + 2) gebildet ist, für hohe Werte der Polarisationsspannung begrenzt ist.

4. Feldeffekttransistor nach Anspruch 1, dadurch gekennzeichnet, daß die dielektrische Schicht (8), welche einen elektrischen Verlust aufweist, eine Dielektrizitätskonstante aufweist, für die gilt : $8 \leqslant \varepsilon \leqslant 30$.

5. Feldeffekttransistor nach Anspruch 4, dadurch gekennzeichnet, daß die dielektrische Schicht (8), die einen elektrischen Verlust aufweist, eine Dicke in der Größenordnung von 50 nm (500 Angström) aufweist und zusammengesetzt ist aus einem der folgenden Materialien : $Ti_xO_y$, $Ta_xO_y$, $Al_xO_y$ oder $Si_xN_y$, wobei jedes dieser Materialien in nicht-stöchiometrischen Proportionen und mit Metall angereichert ist.

6. Feldeffekttransistor nach Anspruch 5, dadurch gekennzeichnet, daß der spezifische Widerstand der dielektrischen Schicht (8), die mit einem elektrischen Verlust behaftet ist, durch Dotierung des sie bildenden Materials mit einem Metall gesteuert ist.

7. Feldeffekttransistor nach Anspruch 1, dadurch gekennzeichnet, daß :
— die erste, den Schottky-Übergang bildende Metallisierung (7) mit einem Metall wie Ti und Al gebildet ist,
— die zweite Metallisierung (9), welche das Steuergate bildet, aus Metallen gebildet ist, welche auf der dielektrischen Schicht (8) gut haften, beispielsweise Ti-Pt-Au.

8. Feldeffekttransistor nach Anspruch 1, dadurch gekennzeichnet, daß die Gate-Polarisationsspannung, die im Anreicherungsbetrieb an die zweite Metallisierung (9) angelegt wird, wenigstens das Doppelte der Spannung beträgt, die an der ersten Metallisierung (7) zulässig ist, ohne hohe Gateverluste im Vergleich zum Kanalstrom zu erzeugen.

# FIG.1

# FIG.2

FIG.3

FIG.4

FIG.5